# EUROPEAN PATENT SPECIFICATION

(11) **EP 1 667 275 B1**
(45) Date of publication and mention of the grant of the patent: **08.06.2011**
(21) Application number: 05026482.9
(22) Date of filing: 05.12.2005
(51) Int. Cl.: H01M 14/00, H01L 31/04

(54) **Dye-sensitized solar cell and dye-sensitized solar cell module**
Farbstoff-sensibilisierte Solarzelle und Modul einer farbstoff-sensibilisierten Solarzelle
Pile solaire rendue sensible aux colorants et module de pile solaire rendue sensible aux colorants

(30) Priority: 06.12.2004 JP 2004353134
(43) Date of publication of application: 07.06.2006
(73) Proprietor: Sharp Kabushiki Kaisha, Osaka-shi, Osaka 545-8522 (JP)
(72) Inventor: Fuke, Nobuhiro, Ikoma-gun, Nara 636-0153 (JP); Fukui, Atsushi, Kashiba-shi, Nara 639-0225 (JP); Yamanaka, Ryohsuke, Gojyo-shi, Nara 637-0014 (JP)
(74) Representative: Müller - Hoffmann & Partner

(56) References cited:
- WO-A-03/034533
- WO-A-2004/032274
- US-A1- 2003 205 268

## Description

### BACKGROUND OF THE INVENTION

### 1. Field of the Invention

The present invention relates to a dye-sensitized solar cell and a dye-sensitized solar cell module

### 2. Description of the Related Art

As an energy source in place of fossil fuel, solar cells capable of converting sun light to electric power have drawn attention. Presently, some of solar cells using crystalline silicon substrates and thin film silicon solar cells have been used practically. However, the former has a problem of a high production cost of the silicon substrates and the latter has a problem that the production cost is increased since various kinds of gases for semiconductor production and complicated production facilities are required. Therefore, in both solar cells, it has been tried to lower the cost per electric power output by increasing the efficiency of photoelectric conversion; however, the above-mentioned problems still remain while being unsolved.

US 2003/0205268 discloses a photoelectric conversion device comprising a particulate semiconductor layer, wherein the particulate semiconductor layer is prepared by a method comprising a step of irradiating semiconductor particles with electromagnetic wave or a step of heating semiconductor particles at a temperature of 50°C or higher and lower than 350°C under a pressure of 0.05 MPa or lower.

WO 03/034533 A1 relates to an organic dye-sensitized metal oxide semiconductor electrode having a metal oxide conductive film readily produced at low temperature and an organic dye-sensitized solar cell comprising the electrode. The semiconductor electrode comprises a substrate having a transparent electrode on its surface, a metal oxide semiconductor film formed on the transparent electrode, and an organic dye adsorbed on the surface of the semiconductor film. The metal oxide semiconductor film is formed by vapor-phase film-forming.

According to WO 2004/032274 A1 the surface of a metal wiring layer in an electrode substrate is insulation-coated by an insulation layer. In a photoelectric conversion element using this electrode substrate, the metal wiring layer is positively shielded from an electrolyte or the like to effectively prevent its corrosion and a current leakage and improve a photoelectric conversion efficiency. The insulation layer is preferably formed of a material containing a glass component, especially preferably formed by printing paste containing glass frits. The metal wiring layer is preferably formed by a printing method.

As a new type solar cell, there has been proposed a wet type solar cell based on photo-induced electron transfer of a metal complex (see Japanese Patent No. 2664194).

This wet type solar cell comprises: two glass substrates each of which has an electrode on a surface thereof; and a photoelectric conversion layer which contains a photoelectric conversion material having an absorption spectrum in a visible light region by adsorbing a photo-sensitive dye and an electrolytic material and which is sandwiched between the electrodes of two glass substrates.

When the wet type solar cell is irradiated with light, electrons are generated in the photoelectric conversion layer, the generated electrons transfer to the electrodes through an external electric circuit, and the transferred electrons are conveyed to the electrodes opposed owing to the ion in the electrolytic material and turn back to the photoelectric conversion layer. Owing to the series of the flow of the electrons, electric energy is outputted.

However, since the wet type solar cell has a basic structure that the electrolytic solution is injected between the electrodes of two glass substrate, it is possible to produce a trial solar cell with a small surface area, but it is difficult to practically produce a solar cell with a large surface area such as 1 m square.

In such a solar cell, if one solar cell (unit cell) is enlarged in the surface area, the generated current is increased proportional to the area. However, since the resistance component in the transverse direction of the transparent conductive film to be used for the electrode parts is extremely increased, the inner electric resistance in series of the solar cell is increased. As a result, the fill-factor (FF) in the current-voltage characteristics at the time of the photoelectric conversion is lowered, resulting in a problem of decrease of the photoelectric conversion efficiency.

In order to solve the above-mentioned problems, it is proposed to install metal lead wires to a transparent conductive substrate in the light receiving face side of the solar cell (Japanese Unexamined Patent Publication No. 2000-285977).

However, the solar cell with such a structure has high light absorption or reflection, and light reaching the photoelectric conversion layer is decreased, so that the current density to be outputted is lowered, resulting in deterioration of the photoelectric conversion efficiency.

### SUMMARY OF THE INVENTION

The present invention aims to provide a high performance dye-sensitized solar cell and dye-sensitized solar cell module with suppressed decrease of FF, which is caused by increase of the inner resistance in series, at the time of photoelectric conversion and suppressed decrease of light reaching a photoelectric conversion layer.

The present inventors have made investigations to solve the above-mentioned problems and consequently have found that a high performance dye-sensitized solar cell as compared with solar cells by conventional techniques could be obtained by installing a counter electrode layer having apertures on a support made of a light transmitting material in a dye-sensitized solar cell comprising a current collector electrode layer, a photoelectric conversion layer of a porous semiconductor layer adsorbing a dye, a carrier transporting layer, a counter electrode layer, and a sealing layer which are formed between a pair of supports at least one of which is made of a light, transmitting material. Thus, the present inventors have accomplished the present invention.

Accordingly, the present invention provides a dye-sensitized solar cell according to claim 1.

The present invention also provides a dye-sensitized solar cell module comprising two or more of the above-mentioned dye-sensitized solar cells connected in series.

The counter electrode layer of the dye-sensitized solar cell according to the present invention functions as an electrode and has apertures for sufficiently transmitting incident light. Therefore, light which cannot reach the photoelectric conversion layer due to absorption or reflection in conventional dye-sensitized solar cells can enter through the apertures; thus, decrease of the current density to be outputted at the time of photoelectric conversion can be suppressed.

Further, since incident light can be taken sufficiently into the inside of the cell through the apertures, the counter electrode layer may be opaque. Accordingly, the thickness of the counter electrode layer can be sufficiently thickened, so that the electric resistance can be lowered and FF decrease can be suppressed.

According to the present invention, it is possible to provide a high performance dye-sensitized solar cell and dye-sensitized solar cell module as compared with those by conventional techniques.

### BRIEF DESCRIPTION OF THE DRAWINGS

Fig. 1 is a schematic cross-sectional view showing a main part of the layer structure of a dye-sensitized solar cell according to the present invention;
Fig. 2 is a schematic cross-sectional view showing a main part of the layer structure of a dye-sensitized solar cell module according to the present invention; and
Figs. 3A and 3B are schematic plan views showing supports of the dye-sensitized solar cell module according to the present invention.

### DETAILED DESCRIPTION OF THE INVENTION

A dye-sensitized solar cell (hereinafter, referred to as "solar cell") according to the present invention comprises a current collector electrode layer, a photoelectric conversion layer of a porous semiconductor layer adsorbing a dye, a carrier transporting layer, a counter electrode layer, and a sealing layer which are formed between a pair of supports at least one of which is made of a light transmitting material. Herein, the counter electrode layer has apertures and is formed on the support made of the light transmitting material.

Also, a dye-sensitized solar cell module (hereinafter, referred to as "module") according to the present invention comprises at least two solar cells connected in series.

The counter electrode layer of the solar cell according to the present invention has apertures and is formed on a support made of a light transmitting material. That is, the counter electrode layer according to the present invention functions as an electrode and has apertures so as to narrow an effective surface area thereof.

In the present invention, the "apertures of the counter electrode layer" refer to the portions on the support uncovered with the counter electrode layer, and an aperture ratio thereof refers to a ratio of the uncovered area and total area of the support.

Owing to such apertures, without considerably lessening the transmitted light intensity per unit surface area, the resistance value of the counter electrode layer can be lowered.

Practically, formation of the apertures allows light, which cannot conventionally reach the photoelectric conversion layer due to the absorption and reflection in conventional dye-sensitized solar cells, to pass through the apertures and enter. Thus, decrease of the current density to be outputted at the time of photoelectric conversion can be suppressed. Further, since incident light can sufficiently be taken in the inside of the cell through the apertures, the counter electrode layer may be opaque. Accordingly, since the thickness of the counter electrode layer can be sufficiently thickened, the electric resistance can be lowered and FF decrease can be suppressed.

From above-mentioned viewpoint, the counter electrode layer is preferable to have an aperture ratio of 70 to 99%, more preferably 85 to 97.5% per its unit surface area.

If the aperture ratio of the counter electrode layer is less than 70%, the transmitted light intensity per unit surface area is too low to improve solar cell performance; therefore, it is not preferable. On the other hand, if the aperture ratio of the counter electrode layer exceeds 99%, electric resistance is heightened and FF decreases, and the catalyst function of the counter electrode layer to be utilized for the redox reaction is deteriorated. Thus, smooth redox reaction cannot be promoted and high photoelectric conversion efficiency cannot be achieved; therefore, it is also not preferable.

The counter electrode layer is not particularly limited if it has apertures, but it has preferably a thin linear shape, more preferably a stripe shape and/or a lattice shape.

If the counter electrode layer has a stripe shape, the transfer distance of redox molecule in relation to the aperture ratio is shortened and the performance of the solar cell is improved; therefore, it is preferable.

If the counter electrode layer has a lattice shape, in the case a disconnection incident occurs, unlike the stripe shape with which parts impossible to output electric current are inevitably formed, the influence of the disconnection incident can be lessened.

The stripe shape may be composed of thin lines with a line width of 0.1 to 50 µm, preferably 1 to 30 µm, and intervals of 1 to 200 µm, preferably 5 to 100 µm.

If the line width of the stripe is less than 0.1 µm, the resistance is increased; therefore, it is not preferable. On the other hand, if the line width of the stripe exceeds 50 µm, the aperture ratio is decreased so much; therefore, it is not preferable.

Meanwhile, in the case the intervals of the stripe are narrow, unless the line width is made thin, the aperture ratio becomes low. If the line width is so thin, the resistance become high. Therefore, the intervals are preferably 1 µm or more. In the case the intervals of the stripe are wide, it becomes difficult for the redox molecule to move and the resistance is increased, so that the intervals are preferably 200 µm or less in terms of the transportation distance of iodine which is one of redox molecule.

Preferably, the lattice shape has intervals of 5 to 250 µm, preferably 20 to 150 µm; a line width of 0.1 to 50 µm, preferably 1 to 30 µm; and a crossing angle of 80 to 100°, preferably 85 to 95°.

The shape of the lattice may be parallelogrammic, rhombic, rectangular, or regular square.

The line width and the intervals of the lattice may be set because of the same reasons as described.

The crossing angle, that is, the angle of respective two thin lines is preferably set in the above-mentioned range so as to make the transfer distance of the redox molecule to the counter pole short and make the aperture ratio high.

The thickness of the counter electrode layer is about 0.5 to 30 µm.

The material composing the counter electrode layer may be those which can activate redox reaction of the carrier transporting layer, which will be described later, and examples thereof may include platinum, palladium, carbon (carbon black, graphite, glass carbon, amorphous carbon, hard carbon, soft carbon, carbon whisker, carbon nanotube, fullerene) and the like. In particular, platinum is preferable in terms of catalytic function and conductivity.

However, platinum is expensive; therefore, a use amount thereof is preferably reduced in terms of cost. Further, it is preferable that each layer is provided while dividing the function of the counter electrode layer into a catalyst function and a conductive function. That is, the counter electrode layer preferably includes a catalyst layer and/or a conductive layer.

The catalyst function for supporting the reaction of redox molecule is determined from the surface area and the catalytic function. For the reason that metal having a resistance value lower than that of platinum is also present, it is preferable that platinum is used only for the catalyst function and a material having a low resistance value is used for a portion which transports electrons.

Examples of the material composing the catalyst layer may include platinum, palladium, carbon (carbon black, graphite, glass carbon, amorphous carbon, hard carbon, soft carbon, carbon whisker, carbon nanotube, fullerene) and the like. In particular, platinum is preferable in terms of catalytic function and conductivity.

On the other hand, examples of the material composing the conductive layer may include gold, silver, copper, aluminum, nickel, tungsten, molybdenum and the like.

It is preferable to successively form the conductive layer and the catalytic layer on a support by using these materials.

With such a constitution, not only the catalyst function and the conductive function of the counter electrode layer can be satisfied but also, if a highly corrosive material is used for the carrier transporting layer, corrosion of the material of the conductive layer can be prevented by using the highly corrosion resistant and highly catalytic material.

Next, preferable embodiments of the solar cell of the present invention will be described with reference to drawings. The illustrated embodiments are only examples for better understanding, and it is not intended that the present invention be limited to the illustrated embodiments. Modifications and substitutions to specific process conditions and structures can be made.

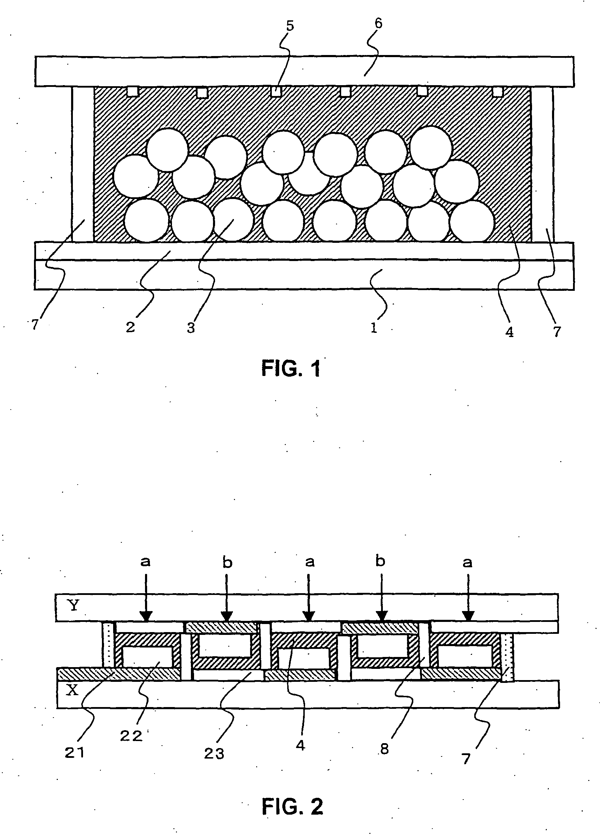

Fig. 1 is a schematic cross-sectional view showing a main part of the layer structure of a solar cell according to the present invention.

The solar cell comprises a current collector electrode 2 for collecting electrons generated on one face of a first support 1, a photoelectric conversion layer 3 of a porous semiconductor layer adsorbing a dye, a carrier transporting layer 4, a counter electrode layer 5 having apertures and formed (disposed) on a second support 6, and a sealing layer 7 formed in the outer peripheral of the photoelectric conversion layer 3.

Hereinafter, other constituent elements will be described.

### (Support)

The supports (the first support and the second support in Fig. 1) are required to have light transmitting property in the part to be a light receiving face of a solar cell, so that at least one is made of a light transmitting material and, for example, use of a light transmitting material for the second support makes it possible to obtain a solar cell in which light can enter from the second support side. Also, a solar cell may be configured that in which light can enter from both faces by using a light transmitting material for both faces.

In the present invention, "light transmitting property" means that light with wavelength to which at least the dye in the photoelectric conversion layer has effective sensitivity is substantially transmitted, but does not necessarily mean that light rays in full wavelength range are transmitted.

The material composing the support is preferably those which have heat resistance at 250°C or more and the thickness thereof is preferably about 0.2 to 5 mm.

Examples of the material composing the support may include glass substrates of soda glass, fused quartz glass, crystalline quartz glass, and synthetic quartz glass; heat resistant resin sheets such as a flexible film; metal sheets, and the like.

Examples of the flexible film (hereinafter, referred to as "film") may include long time weathering resistant sheets and films of polyesters, acrylic polymers, polyimide, Teflon (registered trademark), polyethylene, polypropylene, and poly(ethylene terephthalate) (PET).

In the case other layers are formed on the support through a heating process, for example, in the case the conductive layer is formed on the first support by heating at about 250°C, Teflon (registered trademark) having heat resistant at 250°C or more is particularly preferable among the film materials.

The support may have recessed parts for embedding the current collector electrode layer. The supports may be utilized when the completed solar cell is attached to other constructions. That is, it is made easy to attach the peripheral parts of the supports such as glass substrates to other support bodies by using metal processing members and screws.

### (Current collector electrode layer)

The current collector electrode layer is formed on a support and has a function of collecting electrons generated on one face of the support.

Examples of the material composing the current collector electrode layer may include transparent and conductive metal oxides such as ITO (indium-tin compounded oxide), IZO (indium-zinc compounded oxide), fluorine-doped tin oxide, zinc oxide doped with boron, gallium or aluminum, and niobium-doped titanium oxide.

From a viewpoint of conductivity, metals or alloys composed of one or more metals are also preferable. Accordingly, in the case a highly corrosive material is used for the carrier transporting layer, it is preferable to use metals or alloys composed of at least one or more metals capable of corrosion resistant compounds and examples of such material may include tin, titanium, aluminum, zinc, magnesium, indium, molybdenum, tungsten and the like. Among these, zinc; tin and titanium are , particularly preferable.

In general, it is preferable to coat the surface of the metal with a corrosion resistant metal oxide film with a thickness of 10 µm or less. The transparent conductive film materials may be used for the metal oxide.

Accordingly, the current collector electrode layer preferably includes at least one metal layer and/or metal oxide layer.

The thickness of the current collector electrode layer is about 0.3 to 30 µm.

A method for forming the current collector electrode layer on the support is not particularly limited and examples thereof may include common electrode formation methods such as a CVD method, a sputtering method, an electroless plating method, an electrodeposition method, a printing method, and a method of sticking a thin sheet of a metal or an alloy with an adhesive or a pressure sensitive double-coated tape.

If the current collector electrode layer is connected with the porous semiconductor layer by Schottky junction, energy loss occurs because it exceeds the barrier. Therefore, in order to smoothly move the electrons in the photoelectric conversion layer to the current collector electrode layer, the current collector electrode layer is preferable to establish ohmic contact with the porous semiconductor layer composing the photoelectric conversion layer.

In the case the current collector electrode layer is made of the same material as that of the first support, the production process can be simplified; therefore, it is preferable.

### (Carrier transporting layer)

The carrier transporting layer (electrolytic layer) is of a liquid electrolyte, a gel electrolyte, or a molten salt gel electrolyte.

The liquid electrolyte may be liquid substances containing redox molecule and those which are usable generally for batteries and solar cells may be used without any particular limit. Specific examples thereof may include substances containing the redox molecule and solvents capable of dissolving them; substances containing the redox molecule and molten salts capable of dissolving them; and substances containing the redox molecule and solvents and molten salts capable of dissolving them.

Examples of the electrolytes may include combinations of I₂ with metal iodides such as LiI, NaI, KI, CsI and CaI₂ and iodides such as quaternary ammonium iodides, e.g., tetraalkylammonium iodide, pyridinium iodide, and imidazolinium iodide; combinations of Br₂ with metal bromides such as LiBr, NaBr, KBr, CsBr and CaBr₂ and bromides such as quaternary ammonium bromides, e.g., tetraalkylammonium bromide and pyridinium bromide; metal complexes such as ferrocyanic acid salt-ferricyanic acid salt and ferrocene-ferricinium ion; sulfur compounds such as sodium polysulfide, alkylthiol-alkyldisulfide; biologen coloring elements, hydroquinone-quinone, and the like. Two or more of these substances can be use in form of a mixture. Among these, combinations of I₂ with metal iodides such as LiI, pyridinium iodide, and imidazolinium iodide are particularly preferable in terms of the improvement of the open voltage.

Examples of the solvent to be used for the carrier transporting layer may include carbonate compounds such as ethylene carbonate and propylene carbonate; heterocyclic compounds such as 3-methyl-2-oxazolidinone; ether compounds such as dioxane and diethyl ether; ethers such as ethylene glycol dialkyl ether, propylene glycol dialkyl ether, polyethylene glycol dialkyl ether, polypropylene glycol dialkyl ether, ethylene glycol monoalkyl ether, propylene glycol monoalkyl ether, polyethylene glycol monoalkyl ether, and polypropylene glycol monoalkyl ether; alcohols such as methanol and ethanol; polyhydric alcohols such as ethylene glycol, propylene glycol, polyethylene glycol, polypropylene glycol, and glycerin; nitrile compounds such as acetonitrile, glutarodinitrile, methoxyacetonitrile, propionitrile, and benzonitrile; non-protonic polar solvents such as dimethyl sulfoxide and sulfolane; water, and the like.

The gel electrolyte is generally composed of an electrolytic substance and a gelling agent.

Examples of the gelling agent may include polymer gelling agents such as crosslinked polyacrylic resin derivatives, crosslinked polyacrylonitrile derivatives, polyalkylene oxide derivatives, silicone resins, and polymers having nitrogen-containing heterocyclic quaternary compound salt in the side chains, and they can be used preferably.

The molten salt gel electrolyte is generally composed of a gel electrolytic material and an ambient temperature type molten salt.

Examples of the ambient temperature type molten salt may include nitrogen-containing heterocyclic quaternary ammonium compound salts such as quaternary pyridinium salts and imidazolium salts, and they can be used preferably.

The electrolyte concentration in the carrier transporting layer is properly selected in accordance with the various electrolytes and it is preferably in a range of 0.01 to 1.5 mol/L. In this connection, in the case the support each counter electrode layer exists in the light receiving face side in the module according to the present invention, incident light reaches the porous semiconductor layer adsorbing a dye through the electrolytic solution and carriers are excited. Consequently, depending on the electrolytes to be used in unit cells having the counter electrode layer existing in the light receiving face side, the performance may possibly be deteriorated. Therefore, the concentration of the redox electrolyte is preferable to be set in consideration of that point.

In the case the electrolyte is used for the carrier transporting layer, the carrier transporting layer is formed by a method of injecting an electrolytic solution through an injection port formed in the second support to the space surrounded with the first support, the second support and the sealing layer.

In the case the gel electrolyte is used for the carrier transporting layer, the carrier transporting layer is formed by forming the gel electrolyte on the photoelectric conversion layer.

### (Photoelectric conversion layer)

The conversion layer (porous photoelectric conversion layer) is a porous semiconductor layer adsorbing a coloring material.

### (Porous semiconductor layer)

The porous semiconductor layer contains a semiconductor and semiconductors in various morphological state such as granular, film-like or the like can be employed and the film-like type is preferable.

The material composing the porous semiconductor layer may be one or combinations of two or more kinds of conventionally known semiconductors such as titanium oxide, zinc oxide, tungsten oxide, barium titanate, strontium titanate, and cadmium sulfide. Among these, titanium oxide is particularly preferable in terms of the photoelectric conversion efficiency, stability, and safety.

A method for forming a film-like porous semiconductor layer on the current collector electrode layer is not particularly limited and various kinds of conventionally known methods can be exemplified. Specific examples thereof may include (1) a method of applying a paste containing semiconductor particles onto the current collector electrode layer by a screen printing method or ink-jet method and then calcining the paste; (2) a method of forming the film on the current collector electrode layer by a CVD method or MOCVD method using desired raw material gases; (3) a method of forming the film on the current collector electrode layer by a PVD method, an evaporation method, or a sputtering method using solid raw materials; (4) a method of employing a sol-gel method or an electrochemical redox reaction, thereby forming the film on the current collector electrode layer, and the like.

Among the above-exemplified methods, the screen printing method using a paste is particularly preferable since a thick porous semiconductor layer can be produced at a low cost.

In the case the porous semiconductor layer is formed by the screen printing, the printing may be carried out separately several times to lessen streaking after printing method. In the case the printing is carried separately several times, pastes containing semiconductor particles having different materials and particle diameter may be used for the printing.

Examples of the semiconductor particles may include elemental or compound semiconductor particles having proper average particle diameters, for example, about 1 to 500 nm among commercialized particles. A single porous semiconductor layer may contain semiconductor fine particles with different particle diameters.

In order to improve the photoelectric conversion efficiency of the solar cell, it is required to adsorb a large quantity of the dye, which will be described later, in the porous semiconductor layer. Therefore, the film-like porous semiconductor layer is preferable to have a large specific surface area, about 10 to 500 m² / g. The specific surface area in this specification is a value measured by BET adsorption method.

The thickness of the porous semiconductor layer is not particularly limited, but it is preferably in a range of about 0.5 to 50 µm from a viewpoint of the photoelectric conversion efficiency.

A method of forming the porous semiconductor layer using titanium oxide as semiconductor particles will be described more specifically.

At first, titanium isopropoxide (125 ml) is dropwise added to an aqueous nitric acid solution (0.1 M, 750 ml) to cause hydrolysis and the solution is heated (80°C, 8 hours) to obtain a sol solution. After that, the obtained sol solution is heated (230°C, 11 hours) under a pressurizing condition in an autoclave made of titanium to grow the particles, and ultrasonic dispersion (30 minutes) is carried out to prepare a colloidal solution containing titanium oxide particles with an average primary particle diameter of 15 nm. Ethanol in an amount two times as much is added to the obtained colloidal solution and the mixture is centrifuged (5000 rpm) to obtain titanium oxide particles. The "average particle diameter" in this specification is a value measured by SEM observation.

Next, the obtained titanium oxide particles are washed and mixed with a solution obtained by dissolving ethyl cellulose and terpineol in absolute ethanol and stirred to disperse the titanium oxide particles. After that, the mixed solution is heated (50°C) under a vacuum condition (40 mbar) to evaporate ethanol and obtain a titanium oxide paste. The final composition is adjusted such that, for example, titanium oxide solid concentration is 20 wt%, ethyl cellulose is 10 wt% and terpineol is 64 wt%.

Examples of the solvent to be used for preparing a paste containing (suspended) semiconductor particles may include, beside the above-mentioned solvents, glyme type solvents such as ethylene glycol monomethyl ether; alcohol type solvents such as isopropyl alcohol, mixed solvents such as isopropyl alcohol/toluene, water, and the like.

Next, the paste containing the semiconductor particles by the above-mentioned manner is applied onto the conductive layer and calcined to form the porous semiconductor layer. For the drying and calcinning, it is required to properly adjust the conditions such as temperature, time, ambient environments and the like depending on the types of support and the semiconductor particles to be used. calcining may be carried out, for example, under conditions of about 50 to 800°C for about 10 seconds to 12 hours in atmospheric air or an inert gas. The drying and calcining may be carried out once at a constant temperature or two more times at changed temperatures.

The thickness of the porous semiconductor layer is about 1 to 60 µm.

### (Dye)

Examples of the dye to be adsorbed in the porous semiconductor layer and having a function of a photo sensitizer are those having absorption in a wide range of visible light and/or infrared rays. Further, in order to firmly adsorb the dye in the porous semiconductor layer, those having interlocking groups such as carboxylic acid groups, carboxylic hydride groups, alkoxy groups, hydroxyl groups, hydroxyalkyl groups, sulfonic acid groups, ester groups, mercapto groups, and phosphonyl in the dye molecules are preferable. Among these, carboxylic acid groups and carboxylic anhydride groups are particularly preferable. The interlocking groups provide electric bonds making the electron transfer easy between the dye in excited state and the conduction band of the porous semiconductor layer.

Examples of the dye containing the interlocking group may include ruthenium metal complex type dyes, osmium metal complex type dyes, azo type dyes, quinone type dyes, quinonimine type dyes, quinacridone type dyes, squarylium type dyes, cyanine type dyes, merocyanine type dyes, triphenylmethane type dyes, xanthene type dyes, porphyrin type dyes, phthalocyanine type dyes, perillene type dyes, indigo type dyes, naphthalocyanine type dyes, and the like.

An example of the method of adsorbing the dye in the porous semiconductor layer is a method of immersing the porous semiconductor layer formed on the current collector electrode layer in a solution containing the dissolved dye (a solution for dye adsorption).

The solvent for dissolving the dye may be those which can dissolve the dye therein, and specific examples thereof include alcohols such as ethanol; ketones such as acetone; ethers such as diethyl ether and tetrahydrofuran; nitrogen compounds such as acetonitrile; halogenated aliphatic hydrocarbons such as chloroform; aliphatic hydrocarbons such as hexane; aromatic hydrocarbons such as benzene; esters such as ethyl acetate, and water. Two or more kinds of these solvents may be used in form of a mixture.

The concentration of the dye in the solution may properly be adjusted depending on the types of the dye and solvent to be used. In order to improve the adsorption, however, the concentration is more preferable as it is higher and may be, for example, 1 × 10⁻⁴ mol/L or more.

### (Sealing layer)

The sealing layer is important for preventing evaporation of the electrolytic solution and water influx in the cell.

Also, the sealing layer is important for (1) absorbing the stress (impact) of dropping objects affecting to the support and (2) absorbing sagging affecting to the support during use for a long period of time.

The material composing the sealing layer are preferable silicone resins, epoxy resins, polyisobutylene type resins, hot melt resin and glass frit and two or more of them may be used in form of two or more layers. In the case a nitrile type solvent or a carbonate type solvent is used as a solvent for the redox electrolyte, silicone resins and hot melt resins (e.g., ionomer resins), polyisobutylene resins, and glass frit are particularly preferable.

The pattern of the sealing layer is formed by a dispenser in the case of using silicone resins, epoxy resins, or glass frit and by patternwise perforating sheet-like hot melt resins in the case of using the hot melt resins.

The thickness of the sealing layer is preferable to be not more than the sum of the thickness of the component materials existing between the supports for close contact between the counter electrode layer (catalyst layer) and the photoelectric conversion layer.

According to the present invention, a module comprising two or more above-mentioned solar cells connected in series is provided.

In such a module, an insulating layer (a separator) may be provided between the counter electrode layer (catalyst layer) and the photoelectric conversion layer to prevent leakage of carrier transporting layer from a unit cell to the next unit cells to the unit cell.

### (Insulating layer)

The material composing the insulating layer may be commercialized thermosetting and photo-curing resins and films. A practical example is an ethylene type polymer film (trade name: Surlyn, manufactured by DuPont).

The thickness of the insulating layer is preferably about 10 to 100 µm in consideration of the thickness of the photoelectric conversion layer (porous semiconductor layer) and ion mobility in the carrier transporting layer.

In the case Surlyn is used as the insulating layer, a substrate bearing the photoelectric conversion layer and a substrate bearing the counter electrode layer are laminated in such a manner that the photoelectric conversion layer 3 and the counter electrode layer 5 are set face to face while Surlyn is sandwiched between them and then the resulting laminate is heated and thermally bonded to form the insulating layer.

Heating may be carried out in an electric furnace or a drying furnace. The heating temperature is about 70 to 120°C and heating time is about 30 seconds to 30 minutes.

### EXAMPLES

The present invention will be further described by way of examples and comparative examples; however, the present invention is not limited to these examples.

### (Example 1)

A solar cell as shown in Fig. 1 was produced. The production steps will be described below.

### Production of porous semiconductor layer

A substrate bearing a 500 nm-thick current collector electrode layer 2 of SnO₂ was obtained by forming the layer on one face of a first support 1 of an about 1.0 mm-thick glass substrate. A titanium oxide paste (trade name: D / SP, manufactured by Solaronix, Swiss) was applied in 1 cm square shape onto the current collector electrode layer 2 of the substrate by a screen printing method using a screen printing apparatus (model: LS-150, manufactured by Newlong Seimitsu Kogyo Co., Ltd., Japan) and leveled at room temperature for 1 hour. After that, the obtained coating was dried at 80°C in an oven and calcined at 500°C in air to obtain a porous semiconductor layer with a thickness of 30 µm.

### Production of counter electrode layer

A substrate bearing platinum as the counter electrode layer 5 was prepared by forming the layer on one face of a second support 6 of an about 1.0 mm-thick glass substrate by a conventional method. The form of the counter electrode layer had line intervals of 76 µm and aperture ratio of 83%.

### Adsorption of dye

A ruthenium dye (trade name: Ruthenium 620-1H3TBA, manufactured by Solaronix, Swiss) defined by the following formula (1) was dissolved in a solvent mixture of acetonitrile and tert-butanol at 1 : 1 by volume ratio while the concentration of the dye was controlled to be 2 × 10⁻⁴ mol/L and the concentration of DCA (deoxycholic acid) was controlled to be 2 × 10⁻² mol/L to obtain a dye solution for adsorption.

The glass substrate bearing the porous semiconductor layer of titanium oxide was immersed in the dye solution for 40 hours to adsorb the dye in titanium oxide. After that, the substrate was washed with ethanol and dried to form a photoelectric conversion layer 3.

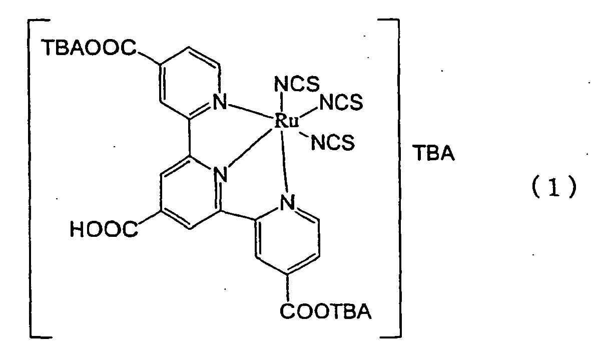

### Production of redox electrolytic solution

Hexylmethylimidazole iodide (HMII), lithium iodide (LiI), tert-butylpyridine (TBP), and iodine (I₂) were dissolved in acetonitrile solvent in amounts to be 0.6 mol/L, 0.1 mol/L, 0.5 mol/L, and 0.01 mol/L, respectively, to obtain a liquid electrolyte (electrolytic solution) to be the carrier transporting layer 4.

### Production of solar cell

The obtained substrate bearing the photoelectric conversion layer 3 and the substrate bearing the stripe-like counter electrode layer were laminated in a manner that the photoelectric conversion layer 3 and the counter electrode layer 5 were set face to face and an ethylene type polymer film (trade name: Surlyn, 50 µm, manufactured by DuPont) was inserted between them and the laminate was heated at 80°C for 15 minutes to form a separator.

Further, a UV-curing resin (trade name: 31x-088, manufactured by Three Bond Co., Ltd., Japan) was applied to the surrounding (between the counter electrode layer 5 and the current collector electrode layer 2) so as to prevent evaporation of a liquid electrolyte to be injected in the next step and quickly UV rays were applied to form a sealing layer 7.

After that, the redox electrolytic solution was injected through an electrolytic solution injection port and the electrolytic solution injection port was closed to form the carrier transporting layer 4. Lead wires were attached to the respective electrodes to complete a solar cell.

Light with AM 1.5 was applied to the counter electrode layer 5 as a light receiving face of the obtained solar cell and the characteristics of the solar cell were evaluated. The evaluation items were short circuit current density (Jsc, mA/cm²), open circuit voltage (Voc, V), FF, and photoelectric conversion efficiency (η, %). The results are shown in Table 1.

### (Comparative Example 1)

A solar cell was produced in the same manner as Example 1, except that a catalyst layer of a film-like platinum without apertures was formed on a conductive layer of a glass substrate, on which the conductive layer of SnO₂ was formed, by chloroplatinic acid treatment, and evaluated. The results are shown in Table 1.

It is clear from the results of Example 1 and Comparative Examples 1 that the solar cell having a structure that the counter electrode layer has apertures (Example 1) is relatively high in FF and exhibits high performance.

### (Example 2)

A solar cell was produced in the same manner as Example 1, except that a current collector electrode layer 2 was formed by forming a 700 nm-thick aluminum film on one face of a first substrate 1 of an about 1.0 mm thick glass substrate by a conventionally known method and forming a 300 nm-thick SnO₂ film by a sputtering method, and evaluated. The results are shown in Table 1.

It is clear from the results of Examples 1 and 2 that the solar cell having a current collector electrode layer comprising two or more materials including a metal (Example 2) is relatively high in Voc and FF and exhibits high performance.

### (Example 3)

A solar cell was produced in the same manner as Example 1, except that a catalyst layer of platinum in a lattice shape (line intervals: 53 µm, crossing angle: 90°, aperture ratio: 83%) was formed on a glass substrate by a conventionally known method and evaluated. The results are shown in Table 1.

It is clear from the results of Examples 3 and Comparative Example 1 that the solar cell having a counter electrode layer with a lattice shape exhibits high performance similarly to the solar cell having a counter electrode layer in stripe shape.

### (Example 4)

A solar cell was produced in the same manner as Example 2, except that a 30 µm-thick porous semiconductor layer was formed by applying a titanium oxide paste in 2 cm square shape and evaluated. The results are shown in Table 1.

### (Comparative Example 2)

A substrate was prepared by forming a 500 nm-thick conductive layer of SnO₂ on one face of a second support 6 of an about 1.0 mm thick glass substrate. A solar cell was produced in the same manner as Example 1, except that a catalyst layer of a 1 µm-thick film-like platinum by platinum deposition by sputtering on the entire face of the conductive layer of the substrate and the porous semiconductor layer was made to be 2 cm square and the solar cell was evaluated. The results are shown in Table 1.

### (Comparative Example 3)

A solar cell was produced in the same manner as Comparative Example 2, except that stripes of recessed parts (intervals: 210 µm, depth: 4 µm) were formed in one face of a first support 1 of an about 1.0 mm thick glass substrate, aluminum was embedded in the recessed parts by a conventional method to form embedded electrodes in stripe form (intervals: 210 µm, aperture ratio: 90%) and then a 600 nm-thick SnO₂ was formed on the entire face by a conventional method to form a current collector electrode layer 2 (in-plane structure) and the solar cell was evaluated. The results are shown in Table 1.

It is clear from the results of Example 4 and Comparative Examples 2 and 3 that the solar cell having apertures in the counter electrode layer and the current collector electrode layer in at least monolayer structure and containing a metal layer and/ or a metal oxide layer (Example 4) is relatively high in FF and exhibits high performance as compared with solar cells (Comparative Examples 2 and 3) having no aperture in the counter electrode layer and using the transparent conductive film and grid electrode for the current collector electrode layer.

### (Example 5)

A solar cell was produced in the same manner as Example 4, except that a conductive layer of a 3 µm-thick silver film was formed on one face of a second support of an about 1.0 mm thick glass substrate by a conventional method and then a catalyst layer of a 200 nm-thick film-like platinum was formed by sputtering for forming the counter electrode layer 5 whose pattern is same as Example 1, and the solar cell was evaluated. The results are shown in Table 1.

It is clear from the results of Examples 4 and 5 that the solar cell (Example 5) having a counter electrode layer composed of two or more materials and using a metal for at least one of the materials is relatively high in FF and exhibits high performance.

**Table 1**

| | Jsc (mA/cm²) | Voc (V) | FF | η (%) |
|---|---|---|---|---|
| Example 1 | 17.4 | 0.680 | 0.591 | 6.99 |
| Example 2 | 17.6 | 0.691 | 0.652 | 7.93 |
| Example 3 | 17.5 | 0.689 | 0.658 | 7.93 |
| Example 4 | 17.5 | 0.690 | 0.615 | 7.43 |
| Example 5 | 17.6 | 0.686 | 0.642 | 7.75 |
| Comparative Example 1 | 18.9 | 0.680 | 0.425 | 5.46 |
| Comparative Example 2 | 19.5 | 0.675 | 0.471 | 6.20 |
| Comparative Example 3 | 17.4 | 0.680 | 0.591 | 6.99 |

### (Example 6)

A module was produced by connecting and integrating 5 unit cells in series as shown in Fig. 2.

In Fig. 2, X and Y are transparent substrates (first support = X and second support = Y) and 21 is a current collector electrode layer; 22 is a photoelectric conversion layer; 23 is a counter electrode layer; 4 is a carrier transporting layer; 7 is a sealing layer; and 8 is insulating layer.

As the transparent substrates (substrate X, substrate Y) were used two glass substrates with a size of 85 mm x 60 mm (#7059, thickness: 1.2 mm, manufactured by Corning Inc.).

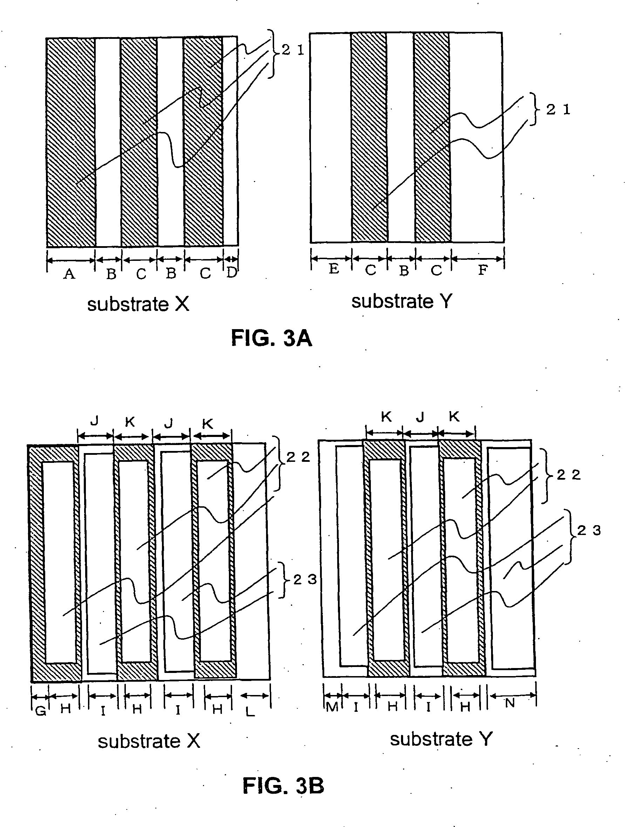

A current collector electrode layer 21 was formed on the substrate X and substrate Y by applying zinc oxide by a conventional method while A, B, C, D, E, and F were respectively adjusted to be 16 mm, 14 mm, 16 mm, 9 mm, 15 mm, and 24 mm as shown in Fig. 3A.

A conductive layer of a silver film with a width 12 mm and a length 55 mm was formed on substrate X and substrate Y by a conventional method and a catalyst layer of a platinum film was formed on the surface by a conventional method to form a counter electrode layer 23 in stripe shape (line intervals: 53 µm, aperture ratio: 90%) while G, H, I, J, K, L, M, and N were respectively adjusted to be 5 mm, 10 mm, 12 mm, 14 mm, 16 mm, 11 mm, 4 mm, and 21 mm as shown in Fig. 3B.

Next, a titanium oxide paste (trade name: D/SP, manufactured by Solaronix, Swiss) was applied in a shape of 10 mm width x 50 mm length onto the counter electrode layer 23 by a screen printing method using a screen printing apparatus (model: LS-150, manufactured by Newlong Seimitsu Kogyo Co., Ltd., Japan) and leveled at a room temperature for 1 hour. After that, the obtained coating was dried at 80°C in an oven and calcined at 500°C in air to obtain a porous semiconductor layer with a thickness of 20 µm.

Next, a ruthenium dye (trade name: Ruthenium 620-1H3TBA, manufactured by Solaronix, Swiss) represented by the above-mentioned formula was dissolved in a solvent mixture of acetonitrile and tert-butanol at 1 : 1 by volume while the concentration of the dye was controlled to be 2 × 10⁻⁴ mol/L and the concentration of DCA (deoxycholic acid) was controlled to be 2 × 10⁻² mol/L to obtain a dye solution for adsorption.

The substrate X and substrate Y on which the porous semiconductor layer was formed were immersed in the dye solution for 40 hours to adsorb the dye in titanium oxide. After that, the substrate was washed with ethanol and dried to form a photoelectric conversion layer 22.

The produced substrate X and substrate Y were laminated in a manner that an ethylene type polymer film (trade name: Surlyn 1855, manufactured by DuPont) cut in 1 mm × 60 mm was stuck as an insulating layer 8 to the boundary of the current collector electrode layers 21 and the counter electrode layers 23 of the respective substrates as shown in Fig. 2 and the laminate was heated at about 100° for 10 minutes to thermally bond them.

An electrolytic solution was produced in the same manner as Example 1 and the solution was injected in unit cell a and unit cell b of the module shown in Fig. 2 based on the capillary effect to form a carrier transporting layer 4 and then a sealing layer 7 was formed by sealing the peripheral parts with an epoxy resin to obtain a module having aperture parts in the counter electrode layers 5.

Using the substrate X of the obtained module as the light receiving layer, the operational characteristics were investigated under radiation of simulated AM 1.5 sun light. The short circuit current was 10.4 mA/cm², open circuit voltage was 3.4 V, FF was 0.58, and module conversion efficiency was 4.2%.

## Claims

1. A dye-sensitized solar cell comprising a current collector electrode layer (2), a photoelectric conversion layer (3) of a porous semiconductor layer adsorbing a dye formed on the current collector electrode layer (2), a carrier transporting layer (4) made of a liquid electrolyte, a gel electrolyte or a molten salt gel electrolyte, a counter electrode layer (5), and a sealing layer (7) which are formed between a pair of supports (1, 6) at least one of which is made of a light transmitting material, wherein the counter electrode layer (5) has apertures and is formed on a flat face of the support (6) made of the light transmitting material.

2. The dye-sensitized solar cell according to claim 1, wherein the counter electrode layer (5) has an aperture ratio of 70 to 99% per its unit surface area.

3. The dye-sensitized solar cell according to claim 1 or 2, wherein the counter electrode layer (5) has a stripe shape and/or a lattice shape.

4. The dye-sensitized solar cell according to claim 3, wherein the stripe shape is composed of thin lines with intervals of 1 to 200 µm.

5. The dye-sensitized solar cell according to claim 3, wherein the lattice shape is composed of thin lines with intervals of 5 to 250 µm and a crossing angle of 80 to 100°.

6. The dye-sensitized solar cell according to anyone of claim 1 to 5, wherein the counter electrode layer (5) includes a catalyst layer and/or a conductive layer.

7. The dye-sensitized solar cell according to claim 6, wherein the catalyst layer is made of platinum.

8. The dye-sensitized solar cell according to anyone of claim 1 to 7, wherein the current collector electrode layer (2) includes at least one metal layer and/or metal oxide layer.

9. A dye-sensitized solar cell module comprising two or more of the above-mentioned dye-sensitized solar cells according to anyone of claims 1 to 8 connected in series.

## Patentansprüche

1. Farbstoff-sensibilisierte Solarzelle, umfassend eine Stromkollektorelektrodenschicht (2), eine fotoelektrische Umwandlungsschicht (3) aus einer porösen Halbleiterschicht, die einen Farbstoff adsorbiert, die auf der Stromkollektorelektrodenschicht (2) ausgebildet ist, eine Trägertransportschicht (4), die aus einem flüssigen Elektrolyten, einem Gelelektrolyten oder einem geschmolzenen Salzgelelektrolyten hergestellt ist, eine Gegenelektrodenschicht (5) und eine Dichtungsschicht (7), die zwischen einem Paar von Trägern (1, 6) ausgebildet sind, von denen mindestens einer aus einem lichtdurchlässigen Material hergestellt ist, wobei die Gegenelektrodenschicht (5) Öffnungen aufweist und auf der flachen Oberfläche des Trägers (6), der aus einem lichtdurchlässigen Material hergestellt ist, ausgebildet ist.

2. Farbstoff-sensibilisierte Solarzelle nach Anspruch 1, wobei die Gegenelektrodenschicht (5) ein Öffnungsverhältnis von 70 bis 99 % pro seiner Einheitsoberfläche aufweist.

3. Farbstoff-sensibilisierte Solarzelle nach Anspruch 1 oder 2, wobei die Gegenelektrodenschicht (5) eine Streifenform und/oder eine Gitterform aufweist.

4. Farbstoff-sensibilisierte Solarzelle nach Anspruch 3, wobei die Streifenform aus dünnen Linien mit Intervallen von 1 bis 200 µm aufgebaut ist.

5. Farbstoff-sensibilisierte Solarzelle nach Anspruch 3, wobei die Gitterform aus dünnen Linien mit Intervallen von 5 bis 250 µm und einem Kreuzungswinkel von 80 bis 100° aufgebaut ist.

6. Farbstoff-sensibilisierte Solarzelle nach einem der Ansprüche 1 bis 5, wobei die Gegenelektrodenschicht (5) eine Katalysatorschicht und/oder eine Leitfähigkeitsschicht umfasst.

7. Farbstoff-sensibilisierte Solarzelle nach Anspruch 6, wobei die Katalysatorschicht aus Platin hergestellt ist.

8. Farbstoff-sensibilisierte Solarzelle nach einem der Ansprüche 1 bis 7, wobei die Stromkollektorelektrodenschicht (2) mindestens eine Metallschicht und/oder Metalloxidschicht aufweist.

9. Ein Farbstoff-sensibilisiertes Solarzellenmodul, das zwei oder mehr der vorstehend beschriebenen Farbstoff-sensibilisierten Solarzellen nach einem der Ansprüche 1 bis 8, die in Serie geschaltet sind, umfasst.

## Revendications

1. Cellule solaire sensibilisée par un colorant, comprenant une couche d'électrode collectrice de courant (2), une couche de conversion photoélectrique (3) constituée d'une couche semi-conductrice poreuse adsorbant un colorant et formée sur la couche d'électrode collectrice de courant (2), une couche de transport de charges (4) constituée d'un électrolyte liquide, d'un électrolyte en gel ou d'un électrolyte en gel dans des sels fondus, une couche de contre-électrode (5) et une couche d'étanchéité (7) qui sont formées entre une paire de supports (1, 6) dont au moins un est constitué d'une matière transmettant la lumière, dans laquelle la couche de contre-électrode (5) présente des ouvertures et est formée sur une face plate sur le support (6) constitué de la matière transmettant la lumière.

2. Cellule solaire sensibilisée par un colorant selon la revendication 1, dans laquelle la couche de contre-électrode (5) présente un rapport d'ouverture de 70 à 99 % de son aire de surface unitaire.

3. Cellule solaire sensibilisée par un colorant selon la revendication 1 ou 2, dans laquelle la couche de contre-électrode (5) présente une forme de bande et/ou une forme de treillis.

4. Cellule solaire sensibilisée par un colorant selon la revendication 3, dans laquelle la forme de bande est composée de lignes fines présentant des intervalles de 1 à 200 µm.

5. Cellule solaire sensibilisée par un colorant selon la revendication 3, dans laquelle la forme de treillis est composée de lignes fines présentant des intervalles de 5 à 250 µm et un angle de croisement de 80 à 100 °.

6. Cellule solaire sensibilisée par un colorant selon l'une quelconque des revendications 1 à 5, dans laquelle la couche de contre-électrode (5) inclut une couche de catalyseur et/ou une couche conductrice.

7. Cellule solaire sensibilisée par un colorant selon la revendication 6, dans laquelle la couche de catalyseur est constituée de platine.

8. Cellule solaire sensibilisée par un colorant selon l'une quelconque des revendications 1 à 7, dans laquelle la couche d'électrode collectrice de courant (2) inclut au moins une couche métallique et/ou une couche d'oxyde métallique.

9. Module de cellule solaire sensibilisée par un colorant comprenant au moins deux cellules solaires sensibilisées par un colorant mentionnées ci-dessus selon l'une quelconque des revendications 1 à 8, raccordées en série.
